# EUROPEAN PATENT APPLICATION

(11) **EP 4 006 194 A1**
(43) Date of publication of application: **01.06.2022**
(21) Application number: 20210198.6
(22) Date of filing: 27.11.2020
(51) Int. Cl.: C23C 14/04, C23C 14/02, C23C 14/06, C23C 14/16, C21D 1/25, C21D 1/74, C21D 1/58, C21D 9/00, C23C 8/02, C23C 8/26, C23C 8/38, C23C 8/80, C23C 28/04, C23C 28/00, B21J 13/02, B21K 1/28

(54) **METHOD OF SELECTIVE PVD DEPOSITION OF MULTI-FUNCTIONAL COATINGS FOR THE PURPOSE OF IMPROVING THE DURABILITY OF FORGING TOOLS**

(71) Applicant: Kuznia Jawor S.A., 59-400 Jawor (PL)
(72) Inventor: Kaszuba, Marcin, 55-106 Zawonia (PL); Widomski, Pawe, 54-106 Wroclaw (PL); Gronostajski, Zbigniew, 53-336 Wroclaw (PL); Rychlik, Marcin, 58- 150 Strzegom (PL); Hawryluk, Marek, 51-210 Wroclaw (PL)

(57) **Abstract**

Method of selective PVD deposition of multi-functional coatings for the purpose of improving the durability of forging tools, in which the entire exterior surface is subjected to the gas or ion nitriding process, as a result of which a layer of nitrides with hardness 800-1200 HV0.1 is formed on the surface layer up to a depth from the surface of approx. 0.15-0.30 mm, after which the tool's surface is subjected to cleaning by etching and heating in Ar + H2 plasma or in another way ensuring removal of nitrides and oxides from the surface and chemical activation of the surface, characteristic in that this layer constitutes the substrate for PVD coatings deposited in further operations, which are deposited selectively using screens, in the specified sequence. First, the Cr/CrN coating is deposited in the part where thermo-mechanical fatigue is dominant, while the remaining area is covered by a screen. Next, the Cr/CrN/AlCrTiSiN coating is deposited in the part where oxidation is dominant, while the remaining area is covered by a screen. Finally, the CrN/AlCrN/AlCrTiN coating is deposited in the part where abrasive wear is dominant, while the remaining area is covered by a screen.

## Description

The object of the invention is a method of selective PVD deposition of multi-functional coatings for the purpose of improving the durability of forging tools, intended for application in industrial hot and semi-hot forging processes.

The main reason for low durability of tools used in industrial forging processes is that their working conditions are extremely heavy. Over the course of operation, these tools are constantly exposed to the action of destructive factors, such as intense thermal fatigue, periodically variable mechanical loads and intense friction under high pressures. The tool's surface layer is particularly exposed to the action of these factors, which is why the majority of destructive mechanisms that occur pertain to this area of the tool, therefore modifying the surface layer properties of forging tools is the most effective way to improve their durability [1].

Attempts to improve the lifetime of forging tools through modification of their near-surface layer have been undertaken around the world for years. One of the oldest methods used for this purpose is the thermochemical treatment that is nitriding. Other attempts to modify the near-surface layer are also undertaken, including by means of: mechanical techniques (e.g. burnishing, ball burnishing, finish rolling, welding techniques such as padding, and the latest methods, which include beam techniques with the application of laser treatment and hybrid techniques based on the application of two or more surface engineering techniques, e.g. hybrid layers consisting of a nitrided layer and PVD coating deposited on it [2], [3].

Nitriding increases tools' resistance to abrasion, fatigue strength, and improves corrosion resistance. Observations of many industrial forging processes in which nitrided tools were applied have proven that this treatment makes it possible to increase tool lifetime several times over. Studies have shown that tools must have a specific, uniform structure for the nitrided layer to improve tool life effectively. Despite mastery of nitriding technology and its many years of application, it only partially meets the expectations of forges when it comes to the durability of tools applied in advanced, high-performance hot die forging processes [4].

The durability of nitrided tools can even be additionally increased by coating the working surface of forging tools with hard, anti-wear coatings. These coatings may be deposited physically (PVD) or chemically (CVD) and are characterized by hardness within the range of 2000-3500HV, a thickness of approx. 1-20µm, and many beneficial mechanical properties, particularly high resistance to abrasion and low adhesion of the forged material to the surface. Combining nitriding and coating in one layer, called a hybrid layer, brings many benefits. The coating protects the nitrided substrate against oxidation and local damage, while the diffusive layer of nitrides forms a stable substrate of varying hardness, constituting an intermediate layer between the relatively soft substrate and the hard coating. This prevents premature cracking and removal of the coating resulting from deformation of the substrate.

It has been demonstrated that hybrid layers clearly improve the durability of metalworking tools. Numerous examples include: AlTiN and AlTiON coatings applied on thixoforming tools [5], CrVN coatings (PVD) and boron-based gradient CVD coatings on dies for hot forging [6], PVD coatings on tools for hammer forging [7], PACVD coatings like TiB2 and TiCn, applied on dies for hot forging [8], FUTURA - TiN/TiAlN and TiN coatings applied on dies for forging of crankshafts [9], multi-layered coatings like (Cr/CrN)x8 [10], Cr/CrN, Cr/CrN/AlCrTiN and CrN/AlCrN/AlCrTiSiN coatings [11] and many others. It has been demonstrated that durability can be increased by 30 to 100% through the application of anti-wear coatings on a nitrided substrate, which economically justifies their application in industrial practice.

Research conducted until now indicates that the following wear mechanisms occur in the surface layer of dies: abrasive wear, thermo-mechanical fatigue, plastic deformation and oxidation. The shape of the tool's working impression also affects the intensity of individual destructive mechanisms to a significant extent [12].

The applied coatings change the process of tool wear and provide new capabilities but also generate new technological problems. These problems may concern tool wear mechanisms, in particular. Coatings that significantly limit the effect of abrasive wear are known, however they are susceptible to cracking as a result of thermo-mechanical fatigue, which is the main cause of their degradation [13]. Next, as a result of cracking, the coating may crumble and fall off the tool's surface, which leads to intensification of the abrasive wear of forging tools in areas particularly exposed to such wear. As demonstrated by studies, coatings based on Ti, with a hardness of approx. 3200 HV, are characterized by resistance to abrasive wear. Meanwhile, coatings resistant to thermo-mechanical fatigue are less resistant to abrasive wear, and because of this, it is justified to apply coatings of this type in areas with particularly high temperature gradation. Coatings that exhibit elevated resistance to thermo-mechanical wear are CrN-based coating with a lower hardness, approx. 2400 HV.

Surface oxidation, which mainly occurs at sites exposed to long-lasting contact with hot material, are among the significant destructive phenomena occurring on the working surface of forging tools' working impression. Al-based PVD coatings exhibit the greatest resistance to high-temperature oxidation.

Conducted studies have demonstrated that different PVD coatings have different properties and are thus subject to wear in a different manner and with varying intensity. The same PVD coating may bring about the effect of increased durability [11] or contribute to reduction of durability, if improperly selected [14]. Considering the diversity of conditions occurring on the surface of forging tools during hot forging and the various properties of coatings, coatings should be selected based on the destructive factors occurring during their exploitation. Therefore, it seems purposeful to apply dedicated coatings for individual areas identified on the working surface of a given tool. In this way, by differentiating properties on the tool's surface, varying resistance to occurring factors can be introduced, thereby extending the tool's total lifetime. This is particularly important because the operating lifetime is limited by the durability of the weakest region of every tool.

The method of selective PVD deposition of multi-functional coatings for the purpose of improving the durability of forging tools, in which the entire surface of the forging tool is subjected to nitriding and cleaning for the purpose of removing nitrides and oxides from the surface, as well as to chemical activation according to the invention, is characterized by the fact that the prepared layer constitutes the substrate for PVD coatings, which are deposited selectively using screens in a specific sequence.

Favorably, the first deposited coating is the Cr/CrN coating on the part where thermo-mechanical fatigue is dominant.

Favorably, the next coating to be deposited is the Cr/CrN/AlCrTiSiN coating on the part where oxidation is dominant.

Favorably, the last deposited coating is the CrN/AlCrN/AlCrTiN coating on the part where abrasive wear is dominant.

Favorably, during deposition of each of the aforementioned coatings, the remaining area is covered using a shutter or screen.

The object of the invention is presented in greater detail in practical examples and in drawings, where:
fig. 1 presents an example of a forging die with marked areas where individual destructive mechanisms are present,
fig. 2 presents the set of screens for selective deposition of PVD coatings onto selected areas: a) view from top, b) view from bottom,
fig. 3 presents the forging die with screen no. 1,
fig. 4 presents the forging die with screen no. 2,
fig. 5 presents the forging die with screen no. 3.

### Example 1

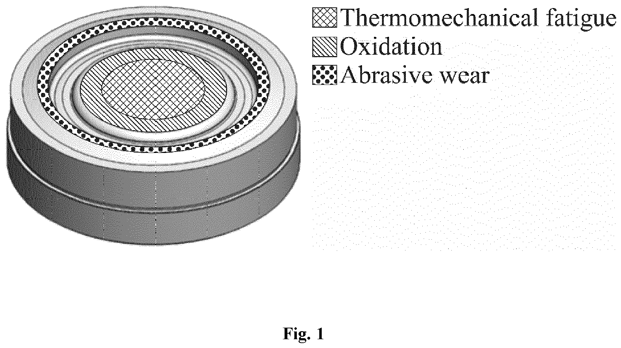

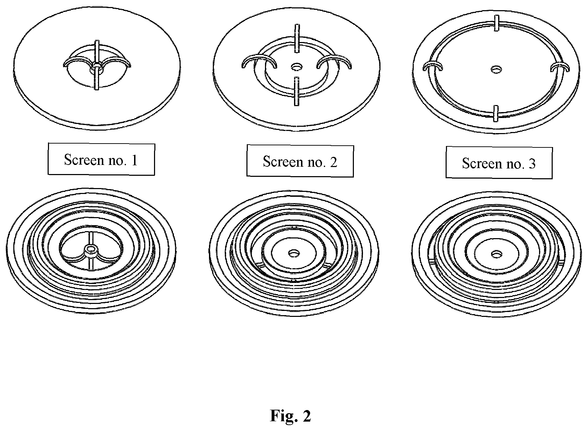

The solution according to the invention, in which the working surface of the forging die presented in fig. 1 was coated in 3 areas with three different types of coatings, and 1 area was left without coating. Areas were selected based on the destructive mechanisms identified in these areas. According to the developed invention, selective coating is possible thanks to the application of a specially prepared set of screens enabling selective deposition of coatings (fig. 2).

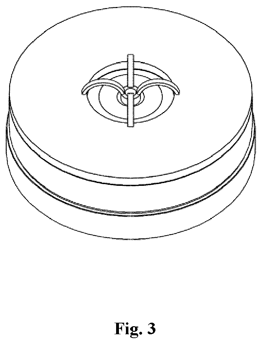

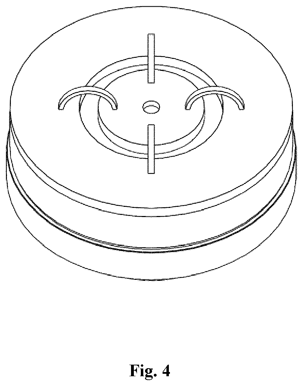

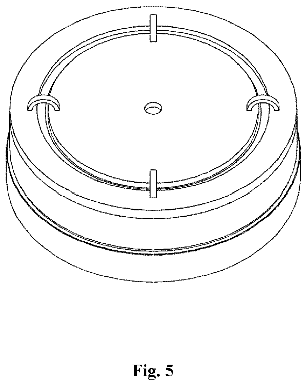

The multi-step treatment process is performed in the following stages:
- stage I - vacuum heat treatment of the entire tool. Based on hardening in oil from 1020°C and double tempering at 600 °C C/1.5 h (cooling in vacuum furnace). The obtained hardness of tools after heat treatment is 46 HRC.
- stage II - operation producing a nitrided layer on the tool's entire surface via the gas nitriding method. The nitriding process is carried out in two steps:
   - step I: nitriding temperature 500 °C, nitrogen potential Np = 7.5 atm-0.5, nitriding time 2 h,
   - step II: nitriding temperature 570 °C, nitrogen potential Np = 0.25 atm-0.5, nitriding time: 24 h.
- stage III - deposition of Cr/CrN coating in the part where thermo-mechanical fatigue is dominant, using screen no. 1 (fig. 3).
- stage IV - deposition of Cr/CrN/AlCrTiSiN coating in the part where oxidation is dominant, using screen no. 2 (fig. 4).
- stage V - deposition of CrN/AlCrN/AlCrTiN coating in the part where abrasive wear is dominant, using screen no. 3 (fig. 5).

### Example 2

Another example of application is production of the tool by the same method as the one described above, through heat treatment and nitriding. This is followed by deposition of the base coating, which may cover the entire working surface of the forging tool. The Cr/CrN coating is applied as the base coating, as it is resistant to thermo-mechanical fatigue, i.e. the mechanism occurring in most areas on the forging tool. Next, an additional layer of coating with different properties is deposited locally in the selected area onto the surface coated with the base coating, i.e. CrN/AlCrN/AlCrTiN coating in the area where abrasive wear is dominant, using screen no. 3. This solution is similar to the solution presented above, however it differs in that the base PVD coating is applied to the entire forging tool, and coatings are deposited selectively on this base coating.

### References:

[1] Kocanda A. Określenie trwalości narz 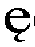 dzia w obróbce plastycznej metali / Estimation of tool life in metal forming. In: Piela, A. Grosman, F. Kusiak, J. Pietrzyk M, ed. *Informatyka w Technologii Metali.* Gliwice: Wydawnictwo Politechniki Śl 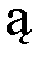 skiej; 2003:213-256.
[2] Hawryluk M. Review of selected methods of increasing the life of forging tools in hot die forging processes. Arch Civ Mech Eng 2016;16(4):845-866.
[3] Mazurkiewicz A, Smolik J. The innovative directions in development and implementations of hybrid technologies in surface engineering. Arch Metall Mater 2015;60(3):2161-2172.
[4] Gronostajski Z, Widomski P, Kaszuba M, et al. Influence of the phase structure of nitrides and properties of nitrided layers on the durability of tools applied in hot forging processes. J Manuf Process 2020;52:247-262.
[5] Birol Y, Isler D. Thermal cycling of AlTiN- and AlTiON-coated hot work tool steels at elevated temperatures. Mater Sci Eng A 2011.
[6] Yilkiran T, Behrens BA, Paschke H, Weber M, Brand H. The potential of plasma deposition techniques in the application field of forging processes. Arch Civ Mech Eng 2012;12(3):284-291.
[7] Podgrajšek M, Glodež S, Ren Z. Failure analysis of forging die insert protected with diffusion layer and PVD coating. Surf Coatings Technol 2015.
[8] Leskovšek V, Podgornik B, Jenko M. A PACVD duplex coating for hot-forging applications. Wear 2009;266(3-4):453-460.
[9] Navinšek B, Panjan P, Gorenjak F. Improvement of hot forging manufacturing with PVD and DUPLEX coatings. Surf Coatings Technol 2001;137(2-3):255-264.
[10] Smolik JA. Hybrid surface treatment technology for increase of hot forging dies. Arch Metall Mater 2012.
[11] Hawryluk M, Gronostajski Z, Widomski P, Kaszuba M, Ziemba J, Smolik J. Influence of the application of a PN+Cr/CrN hybrid layer on the improvement of the lifetime of hot forging tools. J Mater Process Technol 2018;258(226-238).
[12] Altan T, Ngaile G. Cold and Hot Forging: Fundamentals and Applications.; 2005.
[13] Gronostajski Z, Kaszuba M, Hawryluk M, Zwierzchowski M. A review of the degradation mechanisms of the hot forging tools. Arch Civ Mech Eng 2014; 14(4):528-539.
[14] Hawryluk M, Gronostajski Z, Kaszuba M, et al. Application of selected surface engineering methods to improve the durability of tools used in precision forging. Int J Adv Manuf Technol 2017;93(5-8).

## Claims

1. Method of selective PVD deposition of multi-functional coatings for the purpose of improving the durability of forging tools, in which the entire exterior surface is subjected to the gas or ion nitriding process, as a result of which a layer of nitrides with hardness 800-1200 HV0.1 is formed on the surface layer up to a depth from the surface of approx. 0.15-0.30 mm, after which the tool's surface is subjected to cleaning by etching and heating in Ar + H2 plasma or in another way ensuring removal of nitrides and oxides from the surface and chemical activation of the surface, **characterized by** the fact that this layer constitutes the substrate for PVD coatings deposited in further operations, which are deposited selectively using screens, in the following sequence:
a) Cr/CrN coating is deposited in the part where thermo-mechanical fatigue is dominant, while the remaining area is covered by a screen.
b) Cr/CrN/AlCrTiSiN coating is deposited in the part where oxidation is dominant, while the remaining area is covered by a screen.
c) CrN/AlCrN/AlCrTiN coating is deposited in the part where abrasive wear is dominant, while the remaining area is covered by a screen.

2. The method according to claim 1, characteristic in that the base coating is deposited onto the previously nitrided forging tool, and only then are other PVD coatings deposited onto its surface in a selective manner.

3. The method according to any of the previous claims, characteristic in that the surface of the forging tool is coated with coatings by at least two different methods, using coatings with differing chemical composition and functional properties.
